# DEMANDE DE BREVET EUROPEEN

(11) **EP 3 789 779 A1**
(43) Date de publication de la demande: **10.03.2021**
(21) Numéro de dépôt: 19196182.0
(22) Date de dépôt: 09.09.2019
(51) Int. Cl.: G01R 31/28, G01R 31/70

(54) **PROCEDE ET SYSTEME DE TEST D'UN CIRCUIT INTEGRE MONTE SUR UNE PLAQUE DE MONTAGE**

(71) Demandeur: The Swatch Group Research and Development Ltd, 2074 Marin (CH)
(72) Inventeur: CASAGRANDE, Arnaud, 2014 Bôle (CH)
(74) Mandataire: ICB SA

(57) **Abrégé**

Le procédé de test d'un circuit intégré (2) permet de détecter la connexion d'au moins une plage de contact de masse (4a, 4b) du circuit à une masse (6) d'une plaque de montage (8), sur laquelle est monté le circuit intégré. Le circuit comporte encore un bus de test interne (12) relié à une plage de test (18) et à une plage d'alimentation électrique (20), qui sont prévues sur le circuit intégré. La plage d'alimentation électrique est reliée à une alimentation externe (30) pour l'alimentation électrique du circuit. Le procédé comprend les étapes de :
- injecter au niveau de la plage de contact de masse à tester, via une première ligne de test (22) du bus de test interne, un courant de test (i1),
- récupérer, via une seconde ligne de test (24) du bus de test interne (12), la tension (V2) générée par le courant de test ayant traversé la plage de contact de masse à tester et transmettre ladite tension à la plage de test,
- effectuer, via un dispositif de mesure (10) externe au circuit intégré et connecté à la plage de test, une mesure à haute impédance de la tension, et
- déterminer la connexion ou non de la plage de contact de masse à la masse de la plaque de montage en fonction du résultat de la mesure à haute impédance effectuée.

## Description

### DOMAINE TECHNIQUE DE L'INVENTION

L'invention concerne un procédé et un système de test d'un circuit intégré pour détecter ou contrôler la connexion d'au moins une plage de contact de masse du circuit à une masse d'une plaque de montage. Le circuit intégré est monté sur la plaque de montage, cette dernière étant par exemple une plaque à circuit imprimé ou encore un plan de masse.

### ETAT DE LA TECHNIQUE

Dans un circuit intégré, il peut être prévu plusieurs plages (ou broches) de contact de masse pour une connexion à une borne ou ligne de masse externe, telle que par exemple une masse d'une plaque de montage. Les plages de contact de masse relient à la masse des blocs fonctionnels distincts du circuit intégré, afin d'éviter tout couplage de signaux entre ces blocs par l'intermédiaire des différents courants consommés. Or, si la connexion à la masse d'au moins une plage de contact de masse n'est pas effectuée, cela peut réduire les performances du circuit intégré.

Dans les technologies actuelles de circuits intégrés, notamment en technologie CMOS (de l'anglais « Complementary Metal Oxide Semiconductor »), les transistors de type N des différents domaines de masse possèdent tous une connexion intrinsèque au substrat global du circuit. Ce substrat est généralement connecté à la masse. Il existe par conséquent, au travers du substrat du circuit intégré, un chemin résistif interne entre les plages de contact de masse. Par ailleurs, afin d'augmenter la qualité des ancrages à la masse, il peut être prévu de relier entre elles plusieurs plages de contact de masse par connexion métal sur le circuit intégré, fournissant ainsi une masse commune au circuit. Dans ce cas, un chemin résistif interne métallique à faible impédance existe là encore entre les plages de contact de masse reliées entre elles. Par conséquent, dans les deux cas de figure précités, il est très difficile de tester la bonne connexion d'une plage de contact de masse donnée, puisque d'autres plages de contact de masse du circuit sont intrinsèquement amenées au même potentiel par le chemin résistif interne.

Des systèmes de test d'un circuit intégré monté sur un substrat existent, qui permettent de contrôler la connexion entre des plages de contact du circuit et des plages correspondantes du substrat. Le document brevet EP 2 681 741 B1 décrit un tel système de test. Le système met en œuvre un test de continuité des connexions, et comprend un transistor élévateur connecté électriquement à une première alimentation, et un transistor abaisseur connecté à une borne de masse de référence. Le système de test envoie un signal de test à destination des plages de contact du circuit, ce qui permet de déterminer s'il y a une bonne connexion entre les plages de contact et les plages correspondantes du substrat. Toutefois, dans le cas de plages de contact de masse multiples, un tel système de test ne permet pas de distinguer précisément et indépendamment de faibles potentiels, notamment lorsque la différence de potentiel est faible entre deux plages de contact de masse du fait du chemin résistif interne existant. Ainsi le système proposé dans ce document, adapté pour des plages de contact autres que des plages de contact de masse, ne permet pas de tester indépendamment la bonne connexion de plusieurs plages de contact de masse d'un circuit intégré, en obtenant des résultats fiables.

Il existe donc un besoin de pouvoir tester indépendamment et avec précision la bonne connexion d'au moins une plage de contact de masse d'un circuit intégré à une masse externe, notamment à une masse d'une plaque de montage.

### RESUMÉ DE L'INVENTION

L'invention a donc pour but de fournir un procédé et un système de test d'un circuit intégré, qui permettent de tester indépendamment et avec précision la bonne connexion d'au moins une plage de contact de masse du circuit à une masse d'une plaque de montage sur laquelle le circuit est monté.

A cet effet, l'invention concerne un procédé de test d'un circuit intégré pour détecter ou contrôler la connexion d'au moins une plage de contact de masse du circuit à une masse d'une plaque de montage, qui comprend les caractéristiques mentionnées dans la revendication indépendante 1.

Des formes particulières du procédé sont définies dans les revendications dépendantes 2 et 3.

Grâce à l'utilisation du bus de test interne du circuit intégré pour injecter localement un courant de test au niveau de la plage de contact de masse à tester, combinée à une mesure hors circuit et à haute impédance du courant de test ayant traversé cette plage de contact de masse, le procédé selon l'invention permet de tester indépendamment et avec précision la connexion à la masse de la plaque de montage de chacune des plages de contact de masse du circuit. En effet, une telle configuration permet de distinguer précisément et indépendamment de faibles potentiels, notamment lorsque la différence de potentiel est faible entre deux plages de contact de masse du fait du chemin résistif interne existant. En outre, l'utilisation du bus de test interne du circuit intégré permet que ce soit le circuit lui-même qui fournisse le courant de test à mesurer, ce qui est avantageux du point de vue de la praticité et de la facilité d'utilisation du système.

A cet effet, l'invention concerne également un système de test d'un circuit intégré pour détecter ou contrôler la connexion d'au moins une plage de contact de masse du circuit à une masse d'une plaque de montage, qui comprend les caractéristiques mentionnées dans la revendication indépendante 4.

Des formes particulières du système sont définies dans les revendications dépendantes 5 à 12.

### BRÈVE DESCRIPTION DES FIGURES

Les buts, avantages et caractéristiques du procédé et du système de test d'un circuit intégré selon l'invention apparaîtront mieux dans la description suivante sur la base d'au moins une forme d'exécution non limitative illustrée par les dessins sur lesquels :
- la figure 1 est une vue en perspective d'un système de test d'un circuit intégré selon l'invention, et
- la figure 2 est un organigramme représentant des étapes d'un procédé de test d'un circuit intégré selon l'invention, mis en œuvre par le système de la figure 1.

### DESCRIPTION DETAILLEE DE L'INVENTION

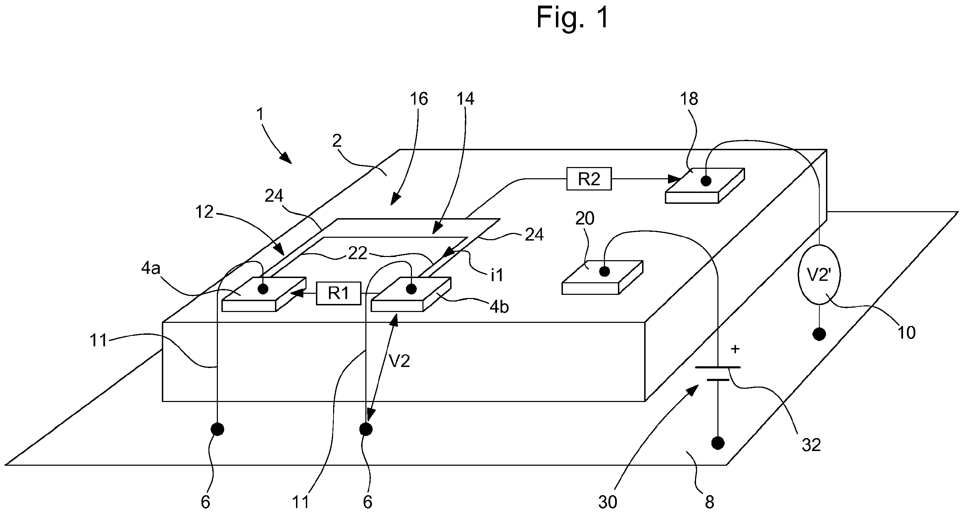

La figure 1 représente un système 1 de test d'un circuit intégré 2. Le système 1 est configuré pour détecter ou contrôler la connexion d'au moins une plage de contact de masse 4a, 4b du circuit 2 à une masse 6 d'une plaque de montage 8. Le système 1 comprend le circuit intégré 2, la plaque de montage 8 sur laquelle le circuit 2 est monté, et un dispositif de mesure 10 relié au circuit intégré 2. Dans l'exemple de réalisation particulier illustré sur la figure 1, la plaque de montage 8 est typiquement une plaque à circuit imprimé de type PCB (de l'anglais « Printed Circuit Board ») ou encore un plan de masse. En variante non représentée, la plaque de montage 8 peut être une plaque d'un boîtier de type boîtier à grille de connexion. Plus généralement, la plaque de montage 8 peut être tout type de plaque sur laquelle un circuit intégré 2 peut être monté.

Le circuit intégré 2 comporte au moins une plage de contact de masse 4a, 4b. Dans l'exemple de réalisation particulier illustré sur la figure 1, le circuit intégré 2 comporte deux plages de contact de masse 4a, 4b. Ces plages de contact 4a, 4b, aussi appelées broches de contact, permettent de relier le circuit intégré 2 à une masse extérieure 6 (en l'occurrence ici la masse 6 de la plaque de montage 8) via des connecteurs 11, typiquement des fils conducteurs. De telles connexions permettent d'éviter tout couplage de signaux entre des blocs fonctionnels distincts du circuit 2. Le circuit intégré 2 comporte en outre un bus de test interne 12 ; des moyens 14 pour injecter localement, au niveau d'une plage de contact de masse 4a, 4b à tester, un courant de test i1 ; et des moyens 16 pour récupérer une tension de test V2 générée par le passage du courant de test i1 dans le contact de masse à tester 4a ou 4b. Le circuit intégré 2 comporte également une plage de test 18 et une plage d'alimentation électrique 20, toutes deux reliées au bus de test interne 12.

Le bus de test interne 12 comporte deux premières lignes de test 22 et deux secondes lignes de test 24. Le bus de test interne 12 est par exemple un bus analogique, typiquement un bus analogique différentiel. Les premières et secondes lignes de test 22, 24 sont par exemple constituées de pistes conductrices, telles que des connexions métal prévues sur le circuit intégré 2.

Les moyens 14 d'injection d'un courant de test i1 sont reliés à chacune des plages de contact de masse 4a, 4b, via une des premières lignes de test 22. Dans l'exemple de réalisation particulier illustré sur la figure 1, les moyens 14 sont constitués d'un multiplexeur analogique intégré. Un tel multiplexeur analogique intégré est par exemple un interrupteur, typiquement un transistor à effet de champ à grille métal-oxyde, notamment un transistor à effet de champ à grille métal-oxyde de type N.

Les moyens 16 d'aiguillage de la mesure de tension sont reliés à chacune des plages de contact de masse 4a, 4b, via une des secondes lignes de test 24. Les moyens 16 sont également reliés à la plage de test 18 et sont configurés pour transmettre à la plage de test 18 les tensions de test générées par le passage du courant de test i1 ayant traversé la plage de contact de masse 4a, 4b à tester. Dans l'exemple de réalisation particulier illustré sur la figure 1, les moyens 16 sont constitués d'un multiplexeur analogique intégré. De préférence, le multiplexeur analogique intégré constituant les moyens 16 est un interrupteur intégré à faible impédance. Un tel interrupteur intégré est par exemple un transistor à effet de champ à grille métal-oxyde, notamment un transistor à effet de champ à grille métal-oxyde de type N.

La plage d'alimentation électrique 20 est reliée à une alimentation externe 30 pour l'alimentation électrique du circuit 2. Dans l'exemple de réalisation particulier illustré sur la figure 1, l'alimentation externe 30 est fournie par une résistance connectée à une source de tension d'alimentation 32 prévue sur la plaque de montage ; la résistance n'étant pas représentée sur la figure pour des raisons de clarté. La source 32 est typiquement une source d'alimentation en tension positive, la plage d'alimentation électrique 20 étant dans ce cas la plage ou broche d'alimentation positive. En variante, toute autre source de courant peut être envisagée pour la source de courant externe 30 sans sortir du cadre de la présente invention.

Le dispositif de mesure 10 est connecté à la plage de test 18. Le dispositif de mesure 10 est configuré pour effectuer une mesure à haute impédance de la tension de test V2 fournie en sortie de la plage de test 18. Cette tenson de test en sortie de la plage de test 18 est une tension V2' légèrement différente de la tension V2 du fait de la résistance R2 et des chutes résistives à travers les interrupteurs en liaison au courant de mesure non nul. Le dispositif de mesure 10 est par exemple un système de test standard utilisé en production. Le dispositif de mesure 10 est de préférence également configuré pour déterminer la connexion ou non de la plage de contact de masse 4a, 4b à la masse 6 de la plaque de montage 8 en fonction du résultat de la mesure à haute impédance effectuée, comme cela sera détaillé par la suite.

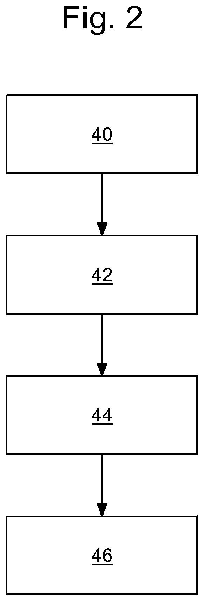

Un procédé selon l'invention de test du circuit intégré 2 pour détecter ou contrôler la connexion d'au moins une plage de contact de masse 4a, 4b du circuit 2 à une masse 6 de la plaque de montage 8, mis en œuvre par le système de test 1, va maintenant être décrit en référence à la figure 2.

On suppose pour la suite que la deuxième plage de contact de masse 4b du circuit 2 est la plage de contact de masse à tester, bien que le procédé pourrait être décrit de la même façon en référence à la première plage de contact de masse 4a de la figure 1. Il est à noter que, du fait de leur connexion intrinsèque à un substrat commun, il existe un chemin résistif interne R1 entre les deux plages de contact de masse 4a, 4b. On notera également qu'une résistance équivalente R2, incluant la présence des moyens 16 de récupération et de transmission de courant, existe du fait de la connexion entre ces moyens 16 et la plage de test 18. Le chemin résistif interne R1 présente par exemple une valeur de résistance sensiblement égale à 3 Ohm. La résistance équivalente R2 présente par exemple une valeur de résistance sensiblement égale à 1 kOhm.

Au cours d'une étape initiale 40, les moyens 14 injectent localement un courant de test i1 au niveau de la plage de contact de masse 4b, via la première ligne de test 22. De préférence, cette injection 40 du courant i1 est une injection d'un courant continu à faible impédance. La valeur d'intensité d'un tel courant de test i1 est par exemple sensiblement égale à 10 mA. Cependant un tel courant de test i1 peut aussi être de type alternatif, permettant d'obtenir, par la mesure de la tension V2 en fonction de la fréquence, une fonction de transfert de la connexion de masse testée.

Au cours d'une étape suivante 42, les moyens 16 récupèrent la tension V2 produite par le courant de test i1 ayant traversé la plage de contact de masse 4b, via la seconde ligne de test 24, et transmettent cette tension à la plage de test 18.

Au cours d'une étape suivante 44, le dispositif de mesure 10 effectue une mesure à haute impédance de la tension de test présente sur la plage de contact de masse 4b. De préférence, le dispositif de mesure 10 est un dispositif de mesure de la tension, et l'étape de mesure 44 consiste en une mesure à haute impédance de cette tension.

Au cours d'une étape finale 46, le système 1 détermine la connexion ou non de la plage de contact de masse 4b à la masse 6 de la plaque de montage 8, en fonction du résultat de la mesure à haute impédance effectuée au cours de l'étape précédente 44. Cette détermination est par exemple effectuée par le dispositif de mesure 10 lui-même. En variante toutefois, cette détermination peut être effectuée par tout dispositif ou module autre que le dispositif de mesure 10, et relié à ce dernier. Dans l'exemple illustratif de la figure 1 où le dispositif de mesure 10 est un dispositif de mesure de tension, lorsque la connexion 11 de la plage de contact de masse 4b vers la masse 6 est rompue, la tension mesurée V2 s'élève. Typiquement, avec les valeurs mentionnées précédemment pour R1, R2 et i1, la valeur de la tension V2 mesurée est sensiblement égale à 1 mV lorsque la connexion 11 est opérationnelle, et est sensiblement égale à 30 mV lorsque la connexion 11 est rompue. Une telle différence entre les valeurs mesurées pour la tension V2 permet au système 1 de déterminer la connexion ou non de la plage de contact de masse 4b à la masse 6 de la plaque de montage 8.

On conçoit ainsi que le procédé et le système selon l'invention permettent de tester indépendamment la bonne connexion de plusieurs plages de contact de masse d'un circuit intégré 2, en obtenant des résultats précis et fiables. Il est à noter que la chute de tension induite par une mesure à haute impédance par le dispositif 10 à 1 MOhm est d'environ 1 pour 1000, et est donc négligeable.

## Revendications

1. Procédé de test d'un circuit intégré (2) pour détecter ou contrôler la connexion d'au moins une plage de contact de masse (4a, 4b) du circuit (2) à une masse (6) d'une plaque de montage (8), le circuit intégré (2) étant monté sur la plaque de montage (8) et comportant, outre la ou les plage(s) de contact de masse (4a, 4b), un bus de test interne (12) relié d'une part à une plage de test (18) et d'autre part à une plage d'alimentation électrique (20), lesdites plages de test et d'alimentation électrique (18, 20) étant prévues sur le circuit intégré (2), la plage d'alimentation électrique étant reliée à une alimentation externe (30) pour l'alimentation électrique du circuit (2), le procédé comprenant les étapes suivantes :
- injecter localement (40) au niveau de la plage de contact de masse (4a, 4b) à tester, via une première ligne de test (22) du bus de test interne (12), un courant de test (i1) ;
- récupérer (42), via une seconde ligne de test (24) du bus de test interne (12), la tension (V2) générée par le courant de test (i1) ayant traversé la plage de contact de masse à tester et transmettre ladite tension (V2) à la plage de test (18) ;
- effectuer (44), via un dispositif de mesure (10) externe au circuit intégré (2) et connecté à la plage de test (18), une mesure à haute impédance de la tension (V2) ; et
- déterminer (46) la connexion ou non de la plage de contact de masse (4a, 4b) à la masse (6) de la plaque de montage (8) en fonction du résultat de la mesure à haute impédance effectuée.

2. Procédé selon la revendication 1, **caractérisé en ce que** l'injection (40) d'un courant de test (i1) au niveau de la plage de contact de masse (4a, 4b) à tester est une injection d'un courant à faible impédance.

3. Procédé selon la revendication 1 ou 2, **caractérisé en ce que** la mesure à haute impédance (44) de la tension de test (V2) peut être effectuée à l'extérieur du circuit.

4. Système (1) de test d'un circuit intégré (2) pour détecter ou contrôler la connexion d'au moins une plage de contact de masse (4a, 4b) du circuit (2) à une masse (6) d'une plaque de montage (8), le système (1) comprenant :
- la plaque de montage (8) ;
- le circuit intégré (2) monté sur la plaque de montage (8), le circuit intégré (2) comportant, outre la ou les plage(s) de contact de masse (4a, 4b), un bus de test interne (12) relié d'une part à une plage de test (18) et d'autre part à une plage d'alimentation électrique (20) prévues sur le circuit intégré (2), la plage d'alimentation électrique (20) étant apte à être reliée à une alimentation externe (30) pour l'alimentation électrique du circuit (2), des moyens (14) pour injecter localement au niveau de la plage de contact de masse (4a, 4b) à tester, via une première ligne de test (22) du bus de test interne (12), un courant de test (i1); et des moyens (16) pour récupérer, via une seconde ligne de test (24) du bus de test interne (12), une tension de test (V2) et pour transmettre ladite tension (V2) à la plage de test (18), et
- un dispositif de mesure (10) connecté à la plage de test (18) du circuit intégré (2), ledit dispositif (10) étant configuré pour effectuer une mesure à haute impédance d'une tension de test (V2) fournie en sortie de la plage de test (18) et pour déterminer la connexion ou non de la plage de contact de masse (4a, 4b) à la masse (6) de la plaque de montage (8) en fonction du résultat de la mesure à haute impédance effectuée.

5. Système (1) selon la revendication 4, **caractérisé en ce que** les moyens (14) pour injecter un courant de test (i1) sont constitués d'un multiplexeur analogique intégré.

6. Système (1) selon la revendication 4 ou 5, **caractérisé en ce que** les moyens (16) pour récupérer la tension de test (V2) et pour transmettre ladite tension (V2) à la plage de test (18) sont constitués d'un multiplexeur analogique intégré.

7. Système (1) selon la revendication 6, **caractérisé en ce que** les moyens (16) pour récupérer la tension de test (V2) et pour transmettre ladite tension (V2) à la plage de test (18) sont constitués d'un interrupteur intégré à faible impédance.

8. Système (1) selon l'une quelconque des revendications 5 à 7, **caractérisé en ce que** les moyens (14) pour injecter un courant de test (i1) et/ou les moyens (16) pour récupérer la tension de test (V2) et pour transmettre ladite tension (V2) à la plage de test (18) sont constitués d'un transistor à effet de champ à grille métal-oxyde, notamment un transistor à effet de champ à grille métal-oxyde de type N.

9. Système (1) selon l'une quelconque des revendications 4 à 8, **caractérisé en ce que** la plaque de montage (8) est choisie parmi le groupe consistant en une plaque à circuit imprimé, un plan de masse, et une plaque d'un boîtier de type boîtier à grille de connexion.

10. Système (1) selon l'une quelconque des revendications 4 à 9, **caractérisé en ce que** le bus de test interne (12) du circuit intégré (2) est un bus analogique, notamment un bus analogique différentiel.

11. Système (1) selon l'une quelconque des revendications 4 à 10, **caractérisé en ce que** le dispositif de mesure (10) est configuré pour effectuer une mesure à haute impédance de la tension (V2) fournie en sortie de la plage de test (18).

12. Système (1) selon l'une quelconque des revendications 4 à 11, **caractérisé en ce que** le courant injecté (i1) peut être de type continu ou encore de type alternatif, permettant d'obtenir, par la mesure de la tension (V2) en fonction de la fréquence, une fonction de transfert de la connexion de masse testée.
